# EUROPÄISCHE PATENTANMELDUNG

(11) **EP 1 835 524 A1**
(43) Veröffentlichungstag der Anmeldung: **19.09.2007**
(21) Anmeldenummer: 06405118.8
(22) Anmeldetag: 16.03.2006
(51) Int. Cl.: H01J 37/34, C23C 14/34, C23C 14/35

(54) **Befestigungsvorrichtung für eine Sputterquelle**

(71) Anmelder: Sulzer Metco AG, 5610 Wohlen (CH)
(72) Erfinder: Eschendorff, Gerald, 5913 TE Venlo (NL)
(74) Vertreter: Sulzer Management AG

(57) **Zusammenfassung**

Eine Befestigungsvorrichtung für eine Sputterquelle in einem Sputterraum umfasst ein stromübertragendes Mittel (2,10,13,15,16,17,18) aus elektrisch und thermisch leitfähigem Material zur Leitung eines Stroms zur Sputterquelle sowie ein abschirmendes Mittel (1,4,5,6,12) zur Abschirmung des stromübertragenden Mittels vom Sputterraum, sodass das stromübertragende Mittel vom Sputterraum elektrisch isolierbar ist. Temperaturbeständige Mittel (1,5) sind vorgesehen, eine Temperaturbeständigkeit und Beständigkeit der Befestigungsvorrichtung gegen elektrische Entladungen insbesondere bei Temperaturen von bis zu 1150°C zu gewährleisten.

## Beschreibung

Sputterquellen für das HS-PVD Beschichtungsverfahren, auch als Gasflusssputterverfahren bekannt, sind im Betrieb unter Vakuumbedingungen Temperaturen zwischen 900 und 1150°C ausgesetzt. Derartige Sputterquellen, werden im Inneren eines verschliessbaren Behälters befestigt, sodass sich ein Sputterraum ausbildet. Der verschliessbare Behälter bildet eine Vakuumkammer aus. In dieser Vakuumkammer befindet sich die Sputterquelle. Die Sputterquelle umfasst zumindest ein Target oder ein Targetsegment, welches das Beschichtungsmaterial enthält. Das Target oder Targetsegment wird an einen Kühlkörper angebracht. Die Anbringung des Targets oder Targetsegments erfolgt über eine Schraubverbindung oder eine Steckverbindung oder eine Kombination beider Verbindungsarten. Der Kühlkörper ist als Block aus wärmeleitfähigem Material ausgeführt, in welchem Kanäle zur Zirkulation eines Kühlmittels angeordnet sind. Der Kühlkörper wird auf der Seite, welche von den Targets oder Targetsegmenten abgewendet ist, an einer Aussenwand befestigt. Diese Aussenwand ist die äussere Begrenzung der Sputterquelle. An diese Aussenwand wird eine Befestigungsvorrichtung zum Eintrag eines elektrischen Stroms in die Sputterquelle angebracht. Eine derartige Befestigungsvorrichtung ist aus dem Oberbegriff von Anspruch 1 bekannt. Eine Befestigungsvorrichtung für die Zuleitung des elektrischen Stroms in eine Sputterquelle umfasst ein stromübertragendes Mittel aus elektrisch leitfähigem Material zur Leitung eines Stroms zur Sputterquelle sowie ein abschirmendes Mittel zur Abschirmung des stromübertragenden Mittels vom Sputterraum ausserhalb der Vakuumkammer, sodass das stromübertragende Mittel vom Sputterraum elektrisch isolierbar ist.

Aus dem Stand der Technik sind Gasfluss-Sputterquellen mit einer Befestigungsvorrichtung bekannt, welche als abschirmendes Mittel eine Abdeckhülse aus einem harten Kunststoffmaterial enthält. Das abschirmende Mittel kann insbesondere aus POM hergestellt sein. POM wird bei BASF als Ultraform ® bezeichnet. Die Ultraform-Standardmarken haben einen engen Schmelzbereich von 164-168°C. Bis in die Nähe dieses Schmelzbereichs können Formteile aus Ultraform kurze Zeit thermisch beansprucht werden, ohne dass eine Materialschädigung eintritt. Hieraus ergibt sich das Problem, dass die thermische Beständigkeit dieser Kunststoffklasse für den angestrebten Temperaturbereich nicht mehr gegeben ist. Infolgedessen kommt es bei Verwendung dieser Werkstoffe als abschirmendes Mittel zur Karbonisierung und zum Verschmelzen der Isolation. In der Folge entstehen hochenergetische Glimmentladungen, die zur Zerstörung der Befestigungsvorrichtung führen können.

Ein weiteres Problem für die Befestigungsvorrichtung aus dem Stand der Technik stellt der Betrieb unter Vakuumbedingungen dar. Die Montage der Befestigungsvorrichtung erfolgt im atmosphärischen Bereich, während das Beschichtungsverfahren im Vakuum abläuft. Unter Vakuumbedingungen können sich stromführende Mittel und/oder abschirmende Mittel voneinander lösen, wobei die Ursache einerseits in der oben genannten thermischen Belastung und den unterschiedlichen Wärmeausdehnungskoeffizienten der verwendeten Materialkombination liegen kann, sowie auch durch den Ansaugdruck, welcher durch die Saugwirkung der Vakuumerzeugungsvorrichtung hervorgerufen wird, bedingt sein kann.

Werden der Sputterquelle nur Ströme von bis zu 40 A bei einer Leistungsdichte von bis zu 40W/cm² Target zugeführt, ist das abschirmende Mittel aus dem Stand der Technik nur für kurze Beschichtungszeiten geeignet, da obengenannte Probleme im Betrieb auftreten können.

Aufgabe der Erfindung ist daher die Erhöhung der Standzeit der Befestigungsvorrichtung, insbesondere der abschirmenden Mittel für die Sputterquelle bei hoher Temperaturbelastung und/oder hoher Leistungsdichte, insbesondere bei Anwendung in einem HS-PVD Beschichtungsverfahren oder einem Gasflusssputterverfahren. Das Gasflusssputterverfahren kann sowohl zur Beschichtung von Bauteilen mit einer metallischen Schicht, als auch zur Beschichtung mit einer keramischen Schicht verwendet werden. Derartige metallische und/oder keramische Schichten werden insbesondere für Bauteile benötigt, die im Betrieb Temperaturen über 1000° ausgesetzt sind, wie insbesondere Einbauten für Gasturbinen, wie Turbinenschaufeln. Beim Gasflusssputterverfahren wird je nach Zusammensetzung des Schichtverbandes ein Inertgas oder ein Reaktivgas benötigt, um das Schichtmaterial von der Beschichtungsquelle abzustäuben. Die Gasatome treffen mit hoher Geschwindigkeit auf das Beschichtungsmaterial, welches in der Beschichtungsquelle auf sogenannten Targets bereitgestellt wird. Das Gas liegt in einem Zustand hoher Energie vor, insbesondere handelt es sich um ein ionisiertes Plasma, sodass die Gasionen aus der Targetoberfläche Atome herausschlagen können. Die Atome werden mit dem Gasstrom mitgerissen und in Richtung des zu beschichtenden Bauteils geleitet. Auf dem Weg zum Bauteil können sie beim reaktiven Gasflusssputtern mit einem Reaktivgas, insbesondere einem sauerstoffhaltigen Gas in Kontakt gebracht werden, wodurch in der Gasphase und/oder auf der Bauteiloberfläche chemische Reaktionen ablaufen.

Die Lösung der Aufgabe umfasst die elektrische Ankoppelung der Sputterquelle durch eine Befestigungsvorrichtung, die mit hochtemperaturbeständigen Mitteln ausgestattet ist.

Die Lösung der Aufgabe ergibt sich aus dem kennzeichnenden Teil von Anspruch 1 wonach temperaturbeständige Mittel vorgesehen sind, die einen Einsatz der Beschichtungsquelle in Leistungsdichten insbesondere bis zu 220W/cm² und Temperaturbereichen insbesondere bis zu 1150°C gewährleisten.

Weitere vorteilhafte Ausgestaltungen der Erfindung ergeben sich aus den Unteransprüchen.

Die temperaturbeständigen Mittel umfassen einen befüllbaren Hohlkörper und/oder zumindest eine elektrisch isolierende Schicht. Eine derartiger Hohlkörper ist in einem vorteilhaften Ausführungsbeispiel aus Edelstahl gefertigt.

Die isolierende Schicht ist nach einem vorteilhaften Ausführungsbeispiel im Inneren des Hohlkörpers angeordnet, wodurch das stromübertragende Mittel zumindest teilweise umschliessbar ist. Der Hohlkörper kann als Hohlzylinder ausgebildet sein, aber auch würfel-, quaderförmige Oberfläche oder mehreckige, insbesondere hexagonale Mantelflächen aufweisen, die auch als Eingriffsfläche für ein Werkzeug oder als Griff ausgebildet sein können. Das stromübertragende Mittel umfasst einen Massivkörper, insbesondere einen Massivzylinder, welcher an einem Ende eine Befestigungsmöglichkeit and der Aussenwand einer Sputterquelle enthält. Diese Befestigungsmöglichkeit kann eine Schraubverbindung umfassen. Der Massivkörper wird in den Hohlkörper eingesetzt, dann wird die isolierende Schicht zwischen Massivkörper und Hohlkörper eingegossen. An dem gegenüberliegenden Ende des Massivkörpers befindet sich ein Anschluss für einen elektrisch leitenden Stab, der insbesondere eine Schraubverbindung umfasst. Der elektrisch leitende Stab wird zumindest teilweise von einem Kunststoffschlauch ummantelt. Das der Schraubverbindung gegenüberliegende Ende des elektrisch leitenden Stabs ist als Steckerelement ausgebildet. Das Steckerelement greift in einen elektrisch leitenden Kern einer Buchse ein. Deren elektrisch leitender Kern ist ebenfalls von einer Schicht aus elektrisch nicht leitendem Material umgeben. An die Buchse schliesst ein Verbindungselement, ein Winkelstecker, ein weiteres Kabel sowie eine weitere Buchse an.

Die isolierende Schicht enthält Anteile eines keramischen Pulvers, sowie ein Klebemittel, wobei ein Steinpulver, insbesondere Steatit, zum Einsatz kommt, und das Klebemittel einen Epoxidharzkleber, insbesondere einen Zweikomponentenkleber umfasst und/oder die Anteile an keramischem Pulver und Klebemittel in einem Bereich um 50 Gew% betragen.

Steatit ist ein keramischer Werkstoff auf der Basis natürlicher Rohstoffe und besteht aus der Hauptkomponente Speckstein (Mg(Si₄O₁₀)(OH)₂), einem natürlichen Magnesiumsilikat und aus Zusätzen von Ton und Feldspat oder Bariumcarbonat. Steatit wird normalerweise dicht gesintert. Die Art des Flussmittels beeinflusst die elektrischen Eigenschaften des Werkstoffes und führt zur Unterscheidung in Normalsteatit und Sondersteatit, der auch Hochfrequenzsteatit genannt wird. Sondersteatit wird in der internationalen Normung als Steatit mit niedrigem Verlustfaktor geführt und eignet sich nicht nur für verlustarme Hochfrequenzbauteile, sondern wegen seiner guten Verarbeitbarkeit auch sehr gut zur Herstellung von Bauteilen mit dünnen und gleichmäßigen Wandstärken. Dadurch werden insbesondere wärmebedingte, gefährliche mechanische Spannungen beherrschbar. Das Material eignet sich aufgrund seiner geringen Schwindung besonders für die wirtschaftliche Fertigung von Bauteilen mit engen Toleranzen und wegen der abrasionsärmsten, Werkzeug schonendsten Rohstoffbasis aller keramischen Werkstoffe für das Trockenpressverfahren. Durch die geringe Schwingung hat sich Steatit auch wegen der hohen Temperaturbelastung in einem Gasflusssputterverfahren als besonders geeigneter Werkstoff für Bauteile unter wechselnder Temperaturbelastung erwiesen. In Kombination mit dem Klebemittel wird ein dauerhafter Verbund erzielt, durch die geringe Schwindung kommt es nicht zu Veränderung des Gefüges aus Klebemittel und Steatit, sodass es nicht zum Versagen der Befestigungsvorrichtung durch Mikrorisse kommt. Der Hohlkörper und der Massivkörper werden aber nicht nur dauerhaft durch die isolierende Schicht verbunden, sondern können auch mit engen Toleranzen gefertigt werden.

Da sich die Aussenwand der Sputterquelle in einem Langzeiteffekt erwärmen kann bzw. kurzzeitige Entladungen zur Karbonisierung der isolierenden Schicht führen können, hat sich die gewählte Mischung von Steatitpulver mit Kunstharz als besonders vorteilhaft erwiesen.

Die Stromaufnahme der Sputterquelle beträgt bei Verwendung der beschriebenen Befestigungsvorrichtung insbesondere bis zu 150A.

Die Leistungsdichte der Befestigungsvorrichtung beträgt insbesondere bis zu 220W/cm² Targetoberfläche.

Das stromübertragende Mittel der Befestigungsvorrichtung umfasst eine Kontaktbuchse zum Anschluss eines Kabelstranges zur Leitung von elektrischem Strom zum Kühlkörper der Beschichtungsquelle, wobei die Kontaktbuchse an einem Kühlmittelanschluss angebracht ist, der in direktem elektrischen Kontakt mit dem Kühlkörper der Beschichtungsquelle steht.

Die Befestigungsvorrichtung wird in einer Beschichtungsanlage verwendet, insbesondere ist sie für eine Beschichtungsanlage für metallisches sowie reaktives Gasflusssputtern geeignet.
Fig. 1 stellt die Anordnung der Befestigungsvorrichtung im Sputterraum dar
Fig. 2 ist ein Schnitt durch die Befestigungsvorrichtung
Fig. 3 ist ein weiteres Ausführungsbeispiel einer Befestigungsvorrichtung
Fig. 4 ist ein weiteres Ausführungsbeispiel einer Befestigungsvorrichtung

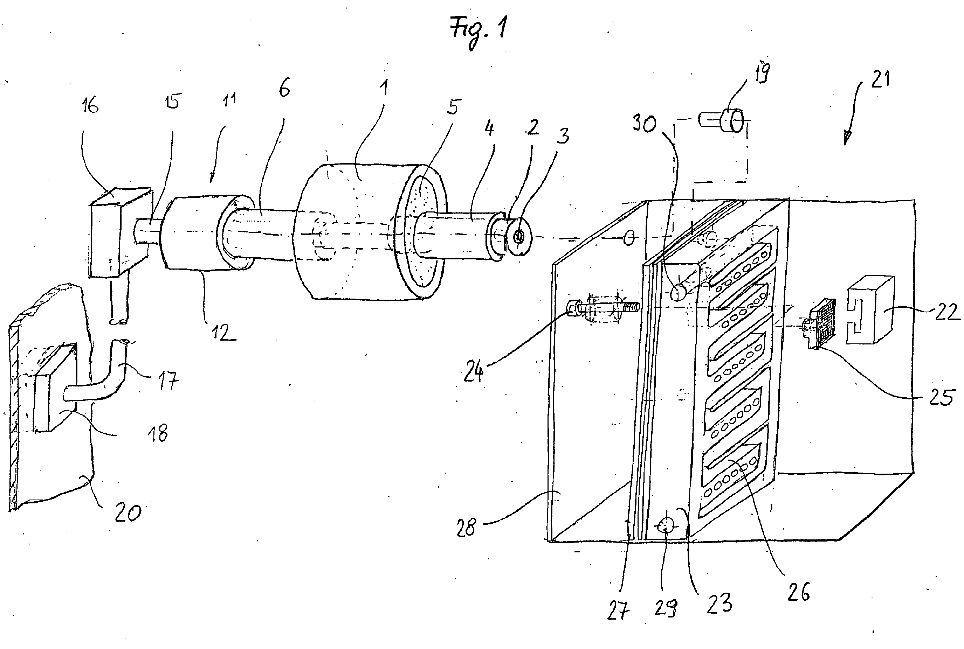

Sputterquellen für das HS-PVD Beschichtungsverfahren werden gemäss Fig. 1 im Inneren eines verschliessbaren Behälters 20 befestigt, sodass sich ein Sputterraum ausbildet. Der verschliessbare Behälter 20 ist zumeist als Vakuumkammer ausgebildet. In dieser Vakuumkammer befindet sich die Sputterquelle 21. Die Sputterquelle umfasst zumindest ein Target oder ein Targetsegment 22, welches das Beschichtungsmaterial enthält. Das Target oder Targetsegment 22 wird an einen Kühlkörper 23 angebracht. Die Anbringung des Targets oder Targetsegments erfolgt über eine Schraubverbindung 24 oder eine Steckverbindung 25 oder eine Kombination beider Verbindungsarten. Der Kühlkörper 23 ist als Block aus wärmeleitfähigem Material ausgeführt, in welchem Kanäle 26 zur Zirkulation eines Kühlmittels angeordnet sind. Der Kühlkörper wird auf der Seite, welche von den Targets oder Targetsegmenten abgewendet ist, an einer Aussenwand 27 befestigt. Diese Aussenwand ist die äussere Begrenzung der Sputterquelle. An diese Aussenwand wird die erfindungsgemässe Befestigungsvorrichtung zum Eintrag eines elektrischen Stroms in die Sputterquelle 21 angebracht. Die Sputterquelle 21 ist gegenüber dem Sputterraum durch eine Isolationszone 28 elektrisch abgeschirmt. Die Isolationszone 28 ist in Fig. 1 als plattenförmiges Element dargestellt. Diese Isolationszone 28 kann auch als Hohlraum ausgebildet sein, wobei durch den Abstand der gegenüberliegenden Hohlraumwände verhindert wird, dass Entladungen zwischen der Sputterquelle 21 und der Behälterwand der Vakuumkammer (20) auftreten. Der Abstand zwischen Sputterquelle und Behälterwand beträgt insbesondere zumindest einige Millimeter und sollte diesen Wert an keiner Stelle unterschreiten, weil sich gerade an diesen Stellen lokale Spannungsspitzen aufbauen können, die zu spontanen Entladungsereignissen führen, welche Schäden an dem Vakuumbehälter oder der Sputterquelle hervorrufen können.

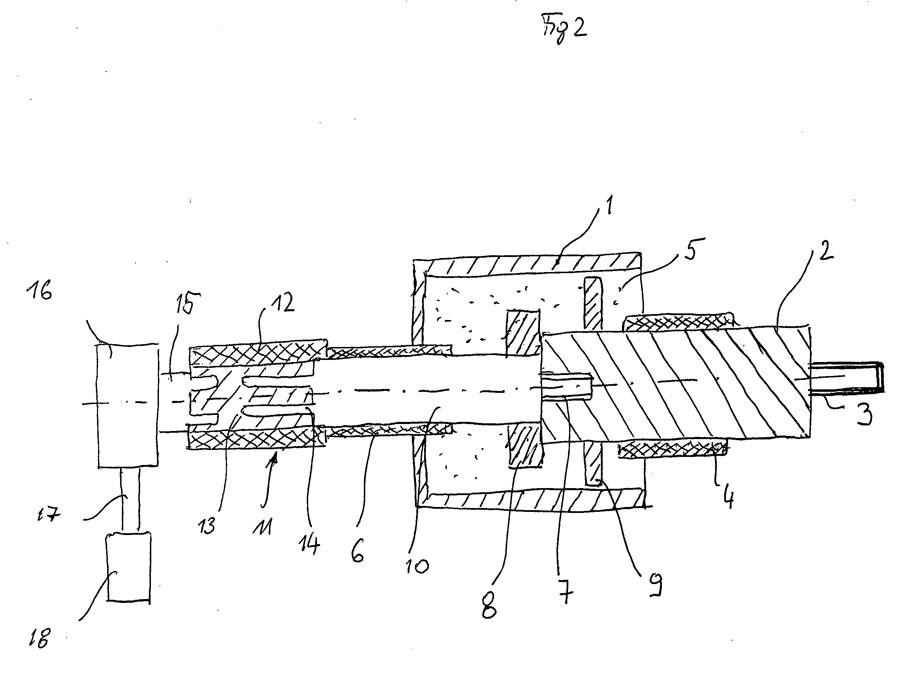

Die Befestigungsvorrichtung für die Sputterquelle 21 in einem Sputterraum umfasst gemäss Fig. 2 ein stromübertragendes Mittel (2,10,13,15,16,17,18) aus elektrisch und thermisch leitfähigem Material zur Leitung eines Stroms zur Sputterquelle 21 sowie ein abschirmendes Mittel (1,4,5,6,12) zur Abschirmung des stromübertragenden Mittels vom Sputterraum. Das stromübertragende Mittel ist vom Sputterraum elektrisch isolierbar. Temperaturbeständige Mittel (1,5) sind vorgesehen, um eine Temperaturbeständigkeit der Befestigungsvorrichtung insbesondere bis zu 1150°C zu gewährleisten. Die temperaturbeständigen Mittel umfassen einen Hohlkörper 1 und/oder zumindest eine elektrisch isolierende Schicht 5. Ein derartiger Hohlkörper 1 ist in einem vorteilhaften Ausführungsbeispiel aus Edelstahl gefertigt. Die isolierende Schicht 5 ist nach einem vorteilhaften Ausführungsbeispiel im Inneren des Hohlkörpers 1 angeordnet, wodurch das stromübertragende Mittel (2,10,13,15,16,17,18) zumindest teilweise umschliessbar ist. Das stromübertragende Mittel umfasst einen Massivkörper, insbesondere einen Massivzylinder 2, welcher an einem Ende eine Befestigungsmöglichkeit 3 für den den Targethalter einer Sputterquelle enthält. Der Massivzylinder 2 stellt den elektrischen Kontakt mit dem Targethalter her, damit Strom in den Targethalter zu den Targets oder Targetsegmenten übertragen werden kann. Der Massivzylinder 2 wird zu Beginn an den Targethalter zusammen mit dem Kunststoffschlauch 4 aufgeschraubt.

Diese Befestigungsmöglichkeit 3 kann eine Schraubverbindung umfassen. Der Massivzylinder 2 wird zumindest teilweise in den Hohlkörper 1 eingesetzt, dann wird die isolierende Schicht 5 zwischen Massivzylinder 2 und Hohlkörper 1 eingegossen. Zur Montage und dem Einfüllen des Klebemittels und des Pulvers werden Montagehilfen (8,9) verwendet, die auch das Einfüllen des Gemisches aus Klebemittel und Pulver ermöglicht, welches bedingt durch seine hohe Viskosität schlechte Fliesseigenschaften aufweist. Bevor die Aushärtung des Klebemittels erfolgt, muss aber der Einfüllvorgang und die Verteilung des Klebemittels im Innenraum des Hohlkörpers abgeschlossen sein. Der Teil des Massivzylinders 2, welcher über den Hohlkörper 1 hinausreicht, wird zumindest teilweise von einem Kunststoffschlauch 4 ummantelt. Der Kunststoffschlauch besteht insbesondere aus einem Polyamid. Da der gesamte Targethalter der Sputterquelle wassergekühlt ist und sich die Schraubverbindung an der Quellenrückseite (d.h. sowohl thermisch vollständig isoliert und gekühlt) also ausserhalb des Hochtemperaturbereichs befindet, ist die Verwendung von Kunststoffschläuchen dann zulässig, wenn man das Auftreten elektrischer Glimmentladungen hierbei ausschliessen kann.

An dem gegenüberliegenden Ende des Massivzylinders 2 befindet sich ein Anschluss 7 für einen elektrisch leitenden Stab 10, der insbesondere eine Schraubverbindung umfasst. Der elektrisch leitende Stab 10 wird zumindest teilweise von einem Kunststoffschlauch 6 ummantelt. Das der Schraubverbindung gegenüber liegende Ende des elektrisch leitenden Stabs ist als Steckerelement 14 ausgebildet. Das Steckerelement 14 greift in einen elektrisch leitenden Kern 13 einer Buchse 11 ein. Deren elektrisch leitender Kern 13 ist ebenfalls von einer Schicht aus elektrisch nicht leitendem Material 12 umgeben. An die Buchse schliesst ein Verbindungselement 15, das als Kabel ausgebildet sein kann, ein Winkelstecker 16, ein weiteres Kabel 17 sowie eine weitere Buchse 18 an. Der insbesondere als M8-Gewinde ausgeführte Teil der Schraubverbindung 3 wird an der in Fig. 1 dargestellten Aussenwand 27 der Sputterquelle 21 festgeschraubt. Der Winkelstecker (15,16) wird bei Montage und/oder Demontage der der Sputterquelle 21, wenn das Beschichtungsmaterial verbraucht ist und die Targets oder Targetsegmente 22 ausgewechselt werden oder Unterhaltsmassnahmen erforderlich sind, in die Buchse (11, 12, 13) ein- oder ausgesteckt. Das Kabel 17 ist insbesondere mit einer Kabellänge von ca. 1,5 bis 3 Meter innerhalb der Vakuumkammer fest mit der Buchse 18 verbunden, da die Quelle unter Umständen vollständig in die Vakuumkammer 20 eingebaut ist. Die Buchse 18 ist mit einer Vakuumstromdurchführung verbunden, die sich an der Vakuumkammerinnenseite befindet und so zur Stromübertragung vom Generator in die Vakuumkammer 20 dient. Diese Ausführung hat den Vorteil, dass man jederzeit und ohne grösseren Aufwand die elektrische Verbindung herstellen oder trennen kann.

Der Hohlkörper 1 sowie der Massivzylinder 2 werden aus Materialien ausreichender mechanischer Festigkeit, die möglichst keine Verunreinigungen enthalten sollen, gefertigt. Verunreinigungen, wie beispielsweise Zn, Sn, Pb können zu einer Schmelzpunkterniedrigung führen. Vorzugsweise bestehen daher der Hohlkörper 1 sowie der Massivzylinder 2 aus rostfreiem Stahl oder aus Hasteloy.

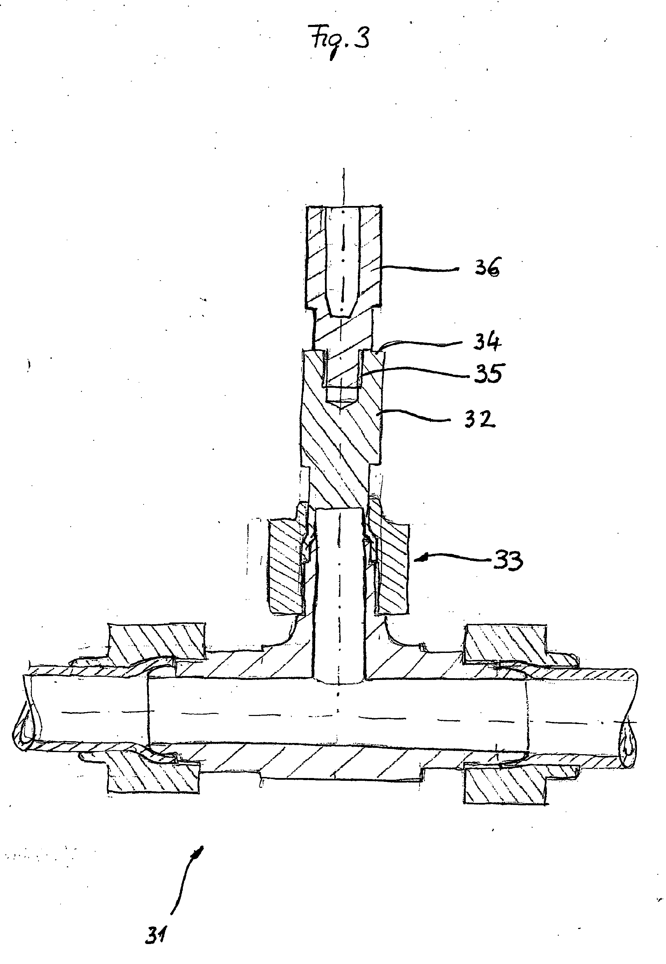

In Fig. 3 ist ein weiteres Ausführungsbeispiel für die Befestigungsvorrichtung dargestellt. Der Stromanschluss nach diesem Ausführungsbeispiel erfolgt an einem bereits vorhandenen Kühlmittelanschluss 31. Der Kühlmittelanschluss 31 befindet sich am in Fig. 1 gezeichneten Kühlmitteleintritt 29 oder am Kühlmittelaustritt 30 aus dem Kühlkörper 23. Der Kühlkörper 6 besteht aus gut wärmeleitfähigem und elektrisch leitfähigem Material, insbesondere aus Kupfer, niedrig legiertem Kupfer, Nickel oder einer Kupfer und/oder Nickel enthaltenden Legierung. Der bestehende Kühlmittelanschluss 31 ist ebenfalls aus gut elektrisch leitfähigem, temperaturbeständigen Material gefertigt, sodass der Kühlmittelanschluss 31 auch zur Leitung des elektrischen Stroms in den Kühlkörper der Beschichtungsquelle verwendbar ist. Dazu wird ein Verbindungselement 32 mit dem Schraubverschluss 33 verschraubt, wobei das Verbindungselement 23 ebenfalls aus einem metallischen Werkstoff besteht. Das Verbindungselement 32 umfasst an dem Ende 34, welches dem im Schraubverschluss eingespannten Ende gegenüberliegt, ein Innengewinde 35 zur Aufnahme einer Kontaktbuchse 36. Die Kontaktbuchse 36 dient der Aufnahme eines nicht dargestellten Kontaktsteckers, welcher in die Sackbohrung 37 eingesteckt werden kann. Von dem Kontaktstecker führt ein Kabelstrang bis zu einer weiteren Kontaktbuchse in der Behälterwand des Vakuumbehälters, der die Beschichtungsquelle enthält. Über diese Kontaktbuchse erfolgt der Anschluss an eine ausserhalb der Vakuumkammer befindliche Stromquelle.

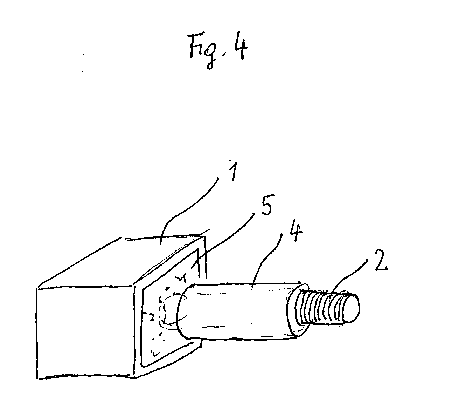

Fig. 4 zeigt ein weiteres Ausführungsbeispiel der Befestigungsvorrichtung, die keinen Stromanschluss aufweist. Die Befestigungsvorrichtung gemäss Fig. 4 umfasst ein stromübertragendes Mittel (2) aus elektrisch und thermisch leitfähigem Material, welches geeignet ist, Strom zur Sputterquelle zu leiten, sowie ein abschirmendes Mittel (1,4,5) zur Abschirmung des stromübertragenden Mittels, womit das stromübertragende Mittel (1,4,5) vom Sputterraum elektrisch isolierbar ist. Temperaturbeständige Mittel (1,5) sind vorgesehen, um eine Temperaturbeständigkeit der Befestigungsvorrichtung insbesondere bis zu 1150°C zu gewährleisten.

Die temperaturbeständigen Mittel umfassen einen Hohlkörper 1 und/oder zumindest eine elektrisch isolierende Schicht 5. Ein derartiger Hohlkörper 1 ist in einem vorteilhaften Ausführungsbeispiel aus Edelstahl gefertigt. Die isolierende Schicht 5 ist nach einem vorteilhaften Ausführungsbeispiel im Inneren des Hohlkörpers 1 angeordnet, wodurch das stromübertragende Mittel 2 vollständig umschliessbar ist. Das stromübertragende Mittel 2 steht nicht in elektrischem Kontakt mit dem Hohlkörper 1, der in diesem Fall vom stromübertragenden Mittel 2 isolierbar ist. Das stromübertragende Mittel umfasst einen Massivkörper, insbesondere einen Massivzylinder 2, welcher an einem Ende eine Befestigungsmöglichkeit 3 für den Targethalter, der Bestandteil einer Sputterquelle ist. Der Massivzylinder 2 stellt den elektrischen Kontakt mit dem Targethalter her, damit Strom in den Targethalter zu den dort angeordneten Targets oder Targetsegmenten übertragen werden kann. Der Massivzylinder 2 wird zu Beginn zusammen mit dem Kunststoffschlauch 4 auf den Targethalter geschraubt. Diese Befestigungsmöglichkeit 3 kann eine Schraubverbindung umfassen. Der Massivzylinder 2 wird zumindest teilweise in den Hohlkörper 1 eingesetzt, dann wird die isolierende Schicht 5 zwischen Massivzylinder 2 und Hohlkörper 1 eingegossen. Zur Montage und dem Einfüllen des Klebemittels und des Pulvers werden in diesem Ausführungsbeispiel nicht dargestellten Montagehilfen verwendet, die auch das Einfüllen eines vorbereiteten Gemisches aus Klebemittel und Pulver ermöglichen, welches bedingt durch seine hohe Viskosität schlechte Fliesseigenschaften aufweist. Bevor die Aushärtung des Klebemittels erfolgt, muss der Einfüllvorgang und die Verteilung des Klebemittels im Innenraum des Hohlkörpers abgeschlossen sein. Der Teil des Massivzylinders 2, welcher über den Hohlkörper 1 hinausreicht, wird zumindest teilweise von einem Kunststoffschlauch 4 ummantelt. Der Kunststoffschlauch besteht insbesondere aus einem Polyamid. Da der gesamte Targethalter der Sputterquelle wassergekühlt ist und sich die Schraubverbindung an der Quellenrückseite (d.h. sowohl thermisch vollständig isoliert und gekühlt), also ausserhalb des Hochtemperaturbereichs befindet, ist die Verwendung von Kunststoffschläuchen dann zulässig, wenn man das Auftreten elektrischer Glimmentladungen wie in den vorherigen Ausführungsbeispielen hierbei ausschliessen kann.

### Bezugszeichenliste

- 1.: Hohlkörper
- 2.: Massivkörper
- 3.: Schraubverbindung
- 4.: Kunststoffschlauch aus Polyamid (elektrischer Isolator)
- 5.: Aushärtbare Klebermischung
- 6.: Kunststoffschlauch
- 7.: Anschluss
- 8.: Montagehilfe
- 9.: Montagehilfe
- 10.: Elektrisch leitender Stab mit Anschlüssen
- 11.: Buchse
- 12.: Elektrisch nichtleitende Schicht der Buchse
- 13.: Elektrisch leitender Kern der Buchse
- 14.: Steckerelement
- 15.: Verbindungselement
- 16.: Winkelstecker
- 17.: Kabel
- 18.: Buchse
- 19.: Schraube
- 20.: Behälter, Vakuumkammer
- 21.: Sputterquelle
- 22.: Target oder Targetsegment
- 23.: Kühlkörper
- 24.: Schraubverbindung
- 25.: Steckverbindung
- 26.: Kanal
- 27.: Aussenwand
- 28.: Isolierschicht
- 29.: Kühlmitteleintritt
- 30.: Kühlmittelaustritt
- 31.: Kühlmittelanschluss
- 32.: Verbindungselement
- 33.: Schraubverschluss
- 34.: Ende
- 35.: Innengewinde
- 36.: Kontaktbuchse

## Patentansprüche

1. Befestigungsvorrichtung für eine Sputterquelle in einem Sputterraum umfassend ein stromübertragendes Mittel (2,10,13,15,16,17,18) aus elektrisch und thermisch leitfähigem Material zur Leitung eines Stroms zur Sputterquelle sowie ein abschirmendes Mittel (1,4,5,6,12) zur Abschirmung des stromübertragenden Mittels vom Sputterraum, sodass das stromübertragende Mittel vom Sputterraum elektrisch isolierbar ist, **gekennzeichnet dadurch, dass** temperaturbeständige Mittel (1,5) vorgesehen sind, eine Temperaturbeständigkeit der Befestigungsvorrichtung insbesondere bis zu 1150°C zu gewährleisten.

2. Befestigungsvorrichtung nach Anspruch 1, wobei die temperaturbeständigen Mittel einen befüllbaren Hohlkörper (1) umfassen.

3. Befestigungsvorrichtung nach Anspruch 1, wobei die temperaturbeständigen Mittel zumindest eine elektrisch isolierende Schicht (5) umfassen.

4. Befestigungsvorrichtung nach Anspruch 3, wobei die isolierende Schicht (5) im Inneren des befüllbaren Hohlkörpers (1) angeordnet ist, wodurch das stromübertragende Mittel (2,10,13,15,16,17,18) zumindest teilweise umschliessbar ist.

5. Befestigungsvorrichtung nach Anspruch 4, wobei die isolierende Schicht (5) Anteile eines keramischen Pulvers, sowie ein Klebemittel enthält, wobei das keramische Pulver insbesondere Steatit enthält, und das Klebemittel einen Epoxidharzkleber, insbesondere einen Zweikomponentenkleber umfasst und/oder die Anteile an keramischem Pulver und Klebemittel insbesondere je 50 Gew% betragen.

6. Befestigungsvorrichtung nach Anspruch 1, wobei die Stromaufnahme der Sputterquelle insbesondere bis zu 150A beträgt.

7. Befestigungsvorrichtung nach Anspruch 1, wobei die Leistungsdichte insbesondere bis zu 220W/cm² beträgt.

8. Befestigungsvorrichtung nach einem der vorhergehenden Ansprüche, wobei das stromübertragende Mittel eine Kontaktbuchse (36) zum Anschluss eines Kabelstranges zur Leitung von elektrischem Strom zum Kühlkörper (23) der Beschichtungsquelle umfasst, wobei die Kontaktbuchse an einem Kühlmittelanschluss (31) angebracht ist, der in direktem elektrischen Kontakt mit dem Kühlkörper (23) der Beschichtungsquelle steht.

9. Beschichtungsanlage mit einer Befestigungsvorrichtung nach einem der vorhergehenden Ansprüche.

10. Verwendung der Befestigungsvorrichtung in einer Beschichtungsanlage für reaktives Gasflusssputtern und/oder metallisches Gasflusssputtern.
